# EUROPEAN PATENT APPLICATION

(11) **EP 4 439 654 A1**
(43) Date of publication of application: **02.10.2024**
(21) Application number: 22899018.0
(22) Date of filing: 23.11.2022
(51) Int. Cl.: H01L 23/427, G06F 1/20

(54) **HEATING ELEMENT COOLING STRUCTURE AND METHOD FOR MANUFACTURING SAME**

(30) Priority: 24.11.2021 KR 20210163821; 18.11.2022 KR 20220155784
(71) Applicant: KMW Inc., Hwaseong-si, Gyeonggi-do 18462 (KR)
(72) Inventor: LEE, Kang Hyun, Hwaseong-si Gyeonggi-do 18442 (KR); KIM, Hyung Seok, Suwon-si Gyeonggi-do 16536 (KR); CHO, Hang Hyeon, Yongin-si Gyeonggi-do 16998 (KR); LEE, Jong Min, Incheon 21377 (KR); JANG, Jae Ho, Pohang-si Gyeongsangbuk-do 37586 (KR)
(74) Representative: SJW Patentanwälte
(86) International application number: PCT/KR2022/018597
(87) International publication number: WO 2023/096336

(57) **Abstract**

According to at least one aspect, the present disclosure provides A method for manufacturing a heating element cooling structure, the method comprising: manufacturing an upper plate, which includes a plurality of column units, by using a press mold method; manufacturing a lower plate by using the press mold method; forming a wick unit at one or more of an inner surface of the upper plate and an inner surface of the lower plate by using a laser; and bonding the upper plate and the lower plate to each other.

## Description

### [TECHNICAL FIELD]

The present disclosure relates to a heating element cooling structure and a method for manufacturing the same.

### [BACKGROUND ART]

The description in this section merely provides background information related to the present disclosure and does not necessarily constitute the related art.

Electronic devices such as computers, servers, and high-performance antennas include electronic components such as IC chips, CPUs, and transmission/reception elements. When these electronic devices operate, a large amount of heat is generated from electronic components (hereinafter referred to as 'heating elements'). When the heating element that generates heat is not cooled, its performance may significantly deteriorate, or in some cases, the heating element may be damaged and difficult to operate. Accordingly, the heating element needs to be cooled effectively.

In recent electronic devices, the spacing between components is narrowing due to slimmerization, higher integration, and higher performance, and the heat generation load is increasing. Accordingly, cooling of the heating elements is essential, and most electronic devices are installed with cooling devices to cool the heating elements.

Heat pipe type or vapor chamber type cooling devices that allow the refrigerant to change phase and circulate according to the temperature difference in the surroundings are widely utilized.

The heat pipe type or vapor chamber type cooling device has a hollow (or internal space) formed and a porous capillary wick unit manufactured by sintering the inside of a pipe-shaped (or panel) body tube (or body panel) made of a heat conductive material.

When the capillary wick unit is manufactured only by a sintering method, there is an issue that the productivity of a product is reduced due to limitations in the sintering process and sintering conditions.

In addition, the heat pipe type or vapor chamber type cooling device involves bonding various configurations such as capillary structures and pillar structures as well as upper and lower plates using methods such as brazing, which complicates the production process and increases costs.

### [DETAILED DESCRIPTION OF INVENTION]

### [TECHNICAL PROBLEMS]

According to a heating element cooling structure and a method for manufacturing the same according to an embodiment, the productivity of a product may be improved by forming a capillary wick unit using a laser.

According to the heating element cooling structure and the method for manufacturing the same according to an embodiment, the productivity and economic efficiency of a product may be improved through a simple manufacturing process by bonding an upper plate, a lower plate, and column units using a laser.

The aspects of the present disclosure are not limited to those mentioned above, and other aspects not mentioned herein will be clearly understood by those skilled in the art from the following description.

### [TECHNICAL SOLUTION]

According to at least one aspect, the present disclosure provides A method for manufacturing a heating element cooling structure, the method comprising: manufacturing an upper plate, which includes a plurality of column units, by using a press mold method; manufacturing a lower plate by using the press mold method; forming a wick unit at one or more of an inner surface of the upper plate and an inner surface of the lower plate by using a laser; and bonding the upper plate and the lower plate to each other.

According to another one aspect, the present disclosure provides A heating element cooling structure, comprising: a lower plate; an upper plate configured to be bonded to an inner surface of the lower plate to form an internal space; a column unit formed to be concave on an outer surface of the upper plate and protrude to an inner surface of the upper plate; and a wick unit formed at one or more of the inner surface of the upper plate and the inner surface of the lower plate and configured to move a refrigerant.

### [EFFECT OF INVENTION]

According to an embodiment, a heating element cooling structure and a method for manufacturing the same can improve the productivity of a product by forming a capillary wick unit using a laser.

According to an embodiment, the heating element cooling structure and the method for manufacturing the same can improve the productivity of a product and reduce production costs through a simple manufacturing process by bonding an upper plate, a lower plate, and column units using a laser.

### [BRIEF DESCRIPTION OF THE DRAWING]

FIG. 1 is a flowchart of a method for manufacturing a heating element cooling structure according to an embodiment of the present disclosure.
FIG. 2 is a perspective view of the heating element cooling structure according to an embodiment of the present disclosure.
FIG. 3 is an exploded perspective view of the heating element cooling structure according to an embodiment of the present disclosure.
FIG. 4 is a cross-sectional view of the heating element cooling structure according to an embodiment of the present disclosure.
FIG. 5 is a diagram illustrating the line spacing using a laser irradiator on a wick unit of the heating element cooling structure according to an embodiment of the present disclosure.
FIG. 6 is a diagram illustrating the pattern shape of the wick unit of the heating element cooling structure according to an embodiment of the present disclosure.

### [BEST MODE FOR CARRYING OUT THE INVENTION]

Hereinafter, some exemplary embodiments of the present disclosure will be described in detail with reference to the accompanying drawings. In the following description, like reference numerals preferably designate like elements, although the elements are shown in different drawings. Further, in the following description of some embodiments, a detailed description of known functions and configurations incorporated therein will be omitted for the purpose of clarity and for brevity.

Additionally, various terms such as first, second, A, B, (a), (b), etc., are used solely to differentiate one component from the other but not to imply or suggest the substances, order, or sequence of the components. Throughout this specification, when a part 'includes' or 'comprises' a component, the part is meant to further include other components, not to exclude thereof unless specifically stated to the contrary. The terms such as 'unit', 'module', and the like refer to one or more units for processing at least one function or operation, which may be implemented by hardware, software, or a combination thereof.

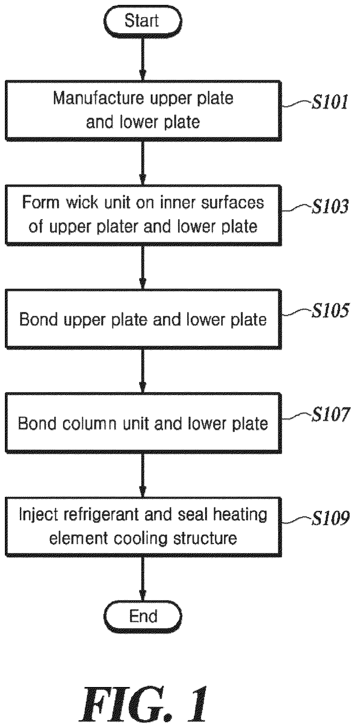

FIG. 1 is a flowchart of a method for manufacturing a heating element cooling structure according to an embodiment of the present disclosure.

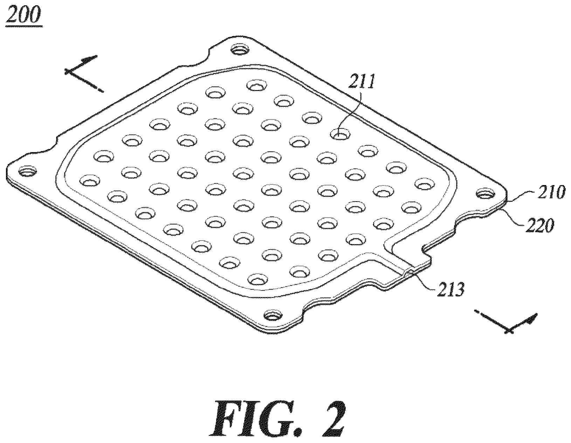

FIG. 2 is a perspective view of the heating element cooling structure according to an embodiment of the present disclosure.

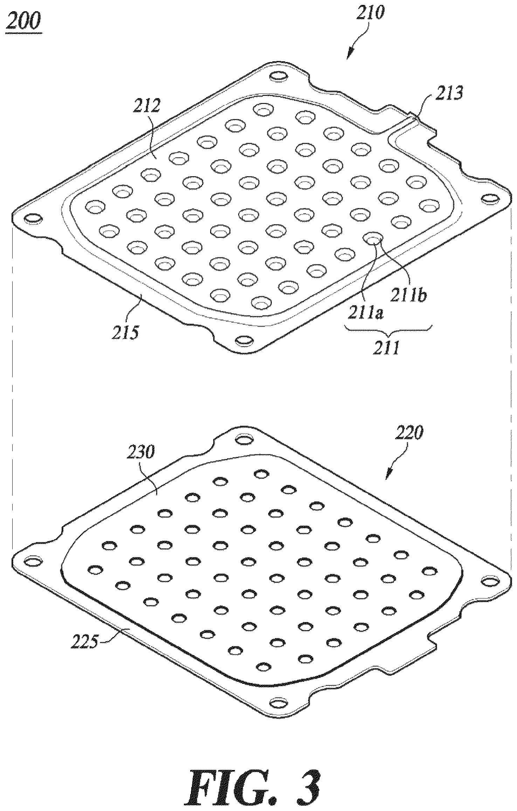

FIG. 3 is an exploded perspective view of the heating element cooling structure according to an embodiment of the present disclosure.

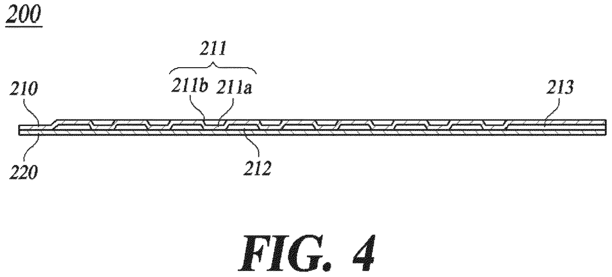

FIG. 4 is a cross-sectional view of the heating element cooling structure according to an embodiment of the present disclosure.

Referring to FIGS. 1 to 4, the method for manufacturing a heating element cooling structure 200 according to an embodiment of the present disclosure includes manufacturing an upper plate 210 and a lower plate 220. The upper plate 210 and the lower plate 220 may be manufactured using a press mold method.

The upper plate 210 may include a column unit 211, an internal space 212, and an inlet 213. The upper plate 210 may be manufactured using the press mold method so that the column unit 211 is formed integrally with the upper plate 210. The column unit 211 may be concave on an outer surface of the upper plate 210 and may be formed to protrude to the upper plate 210 in a bonding direction to the lower plate 220. The upper plate 210 may include a plurality of column units 211 regularly arranged at regular intervals. However, the arrangement of the plurality of column units 211 is not limited thereto, and the plurality of column units 211 may be arranged irregularly.

When the upper plate 210 and the lower plate 220 are bonded, the upper plate 210 may be manufactured to have a predetermined thickness so that the internal space 212 configured to be filled with refrigerant is formed between the upper plate 210 and the lower plate 220.

The method for manufacturing the heating element cooling structure 200 may include forming a wick unit 230 on an inner surface of the upper plate 210 and/or the lower plate 220 (S103). The wick unit 230 may be formed on the inner surface of the upper plate 210 and/or the lower plate 220 using a laser irradiator. The wick unit 230 may be formed by applying heat to the inner surface of the upper plate 210 and/or lower plate 220 using high integrated energy of a laser and scratching or scarring the same to a certain depth or more.

The wick unit 230 may be formed on the remaining portions excluding a portion where the upper plate 210 and the lower plate 220 are bonded to each other on the inner surface of the upper plate 210 and/or the inner surface of the lower plate 220. For example, the wick unit 230 may not be formed on a bonding surface 215 and a bonding unit 211a of the column unit 211 that is bonded to the lower plate 220 on the inner surface of the upper plate 210. The wick unit 230 may not be formed on a bonding surface 225 of the lower plate 220 that is bonded to the bonding surface 215 of the upper plate 210 and the column unit 211 on the inner surface of the lower plate 220.

The method for manufacturing the heating element cooling structure 200 may include bonding the upper plate 210 and the lower plate 220 (S105).

The upper plate 210 and the lower plate 220 may be bonded using laser welding. The laser beam may be irradiated from an upper portion of the upper plate 210 perpendicularly to the upper plate 210 so that the laser beam penetrates the upper plate 210 but does not penetrate the lower plate 220. By laser welding the upper plate 210 and the lower plate 220, the tensile force and airtightness of the heating element cooling structure 200 may be maintained despite the expansion force of the refrigerant filled in the internal space 212.

The method for manufacturing the heating element cooling structure 200 may include bonding the column unit 211 and the lower plate 220 (S107).

The column unit 211 and the lower plate 220 may be bonded using laser welding. A laser beam may be irradiated from an upper portion of the upper plate 210 perpendicularly to the upper plate 210, and toward the concave column unit 211 on an outer surface of the upper plate 210. The laser beam may be irradiated so as to penetrate the column unit 211 but not the lower plate 220. By bonding the column unit 211 and the lower plate 220, it is possible to prevent the column unit 211 from protruding convexly to the outer surface of the upper plate 210 due to expansion of the refrigerant filled in the internal space 212.

After the upper plate 210 and the column unit 211 are bonded to the lower plate 220, refrigerant may be injected into the internal space 212 and the heating element cooling structure 200 may be sealed (S109). The internal pressure may be optimized by filling the inside of the heating element cooling structure 200 with refrigerant and using a vacuum pump. Thereafter, airtightness may be maintained by sealing the heating element cooling structure 200 by bonding the inlet 213 using separate equipment. After sealing, the inlet 213 may be cut when needed.

The heating element cooling structure 200 according to an embodiment of the present disclosure is a heat dissipation component that may apply a heat dissipation method that excludes the induction of a phase change in the refrigerant by a compressor. By transferring heat by causing a phase change solely by heat supplied from the outside at atmospheric pressure without using the compressor, the heating element cooling structure is designed to cool heating elements that generate heat by electrical driving and may be applied to vapor chambers, heat pipes, and heat sinks.

Referring again to FIGS. 2 to 4, the heating element cooling structure 200 according to an embodiment of the present disclosure may include the upper plate 210 and the lower plate 220. The upper plate 210 may include the column unit 211, the internal space 212, the inlet 213, and the bonding surface 215. The upper plate 210 and the lower plate 220 may include the wick unit 230 on their inner surfaces.

Refrigerant may be filled and flow in the internal space 212. When the upper plate 210 and the lower plate 220 are bonded, the inner surface of the upper plate 210 may include the bonding surface 215 of a different height so that the internal space 212 is formed between the upper plate 210 and the lower plate 220. In this connection, the heights of the bonding surface 215 and the column unit 211 may be the same so that the upper plate 210 and the lower plate 220 may be bonded.

The column unit 211 may be formed integrally with the upper plate 210. The upper plate 210 may be manufactured using the press mold method so that the column unit 211 is formed integrally with the upper plate 210. The column unit 211 may be concave on the outer surface of the upper plate 210 and may be formed to protrude to the upper plate 210 in a direction in contact with the lower plate 220. The upper plate 210 may include the plurality of column units 211 regularly arranged at regular intervals. However, the disposition of the plurality of column units 211 is not limited thereto, and the plurality of column units 211 may be arranged irregularly.

The column unit 211 may be formed to protrude from the inner surface of the upper plate 210 in a column shape and may include a bonding unit 211a and an inclined unit 211b. The inclined unit 211b may be formed to form a predetermined angle rather than being perpendicular to the inner surface of the upper plate 210. For example, the angle between the inclined unit 211b and the upper plate 210 may be 45 degrees. This is because, when the inclined unit 211b is perpendicular to the inner surface of the upper plate 210, it is difficult to form the wick unit 230 on the inclined unit 211b. In other words, the heating element cooling structure 200 according to an embodiment of the present disclosure is formed so that the inclined unit 211b of the upper plate 210 and the column unit 211 forms a predetermined angle, and the wick unit 230 is also formed on the inclined unit 211b, thereby increasing the capillarity and improving the mobility of the refrigerant filled therein. As a result, the cooling effect of a heating element may be maximized.

The cross-sectional shape of the bonding unit 211a may be circular or polygonal. The shape of the column unit 211 composed of the bonding unit 211a and the inclined unit 211b may be a truncated cone or a polygonal pyramid shape. However, it should be noted that the shape of the column unit 211 is not limited thereto, and may have various shapes that may perform the same function as the disclosed column unit 211.

The wick unit 230 may be formed on the inner surface of the upper plate 210 and/or the lower plate 220. The wick unit 230 may be formed by applying heat to the inner surface of the upper plate 210 and/or the inner surface of the lower plate 220 using high integrated energy of a laser and scratching or scarring the same to a certain depth or more. The wick unit 230 may be formed to flow the refrigerant filled in the internal space 212 using capillarity.

When heat is transferred from the heating element disposed on the outside of the lower plate 220 to the heating element cooling structure 200, the refrigerant filled inside the heating element cooling structure 200 undergoes a phase change due to the transferred heat. The phase-changed refrigerant moves toward the upper plate 210 through the wick unit 230 by surface tension and/or capillary force to transfer heat, and the heat transferred to the upper plate 210 may be emitted to the outside.

The wick unit 230 may be formed on a portion where the upper plate 210 and the lower plate 220 are not bonded to each other on the inner surface of the upper plate 210 and/or the inner surface of the lower plate 220. The wick unit 230 may be formed on the remaining portions excluding the portion bonded to the lower plate 200 on the inner surface of the upper plate 210. The wick unit 230 may not be formed on the bonding surface 215 of the upper plate 210 and the bonding unit 211a of the column unit 211, but the wick unit 230 may be formed on the inner surface of the upper plate 210 and the inclined unit 211b of the column unit 211 excluding the above.

The wick unit 230 may be formed on the remaining portions excluding the portion bonded to the upper plate 210 on the inner surface of the lower plate 220. The wick unit 230 is not formed on the bonding surface 225 of the lower plate 220 that is bonded to the upper plate 210. A plurality of bonding surfaces 225 in contact with the plurality of column units 211 may be formed between the wick units 230 of the lower plate 220. The plurality of bonding surfaces 225 may be arranged regularly at regular intervals corresponding to the plurality of column units 211. However, the arrangement of the plurality of bonding surfaces 225 is not limited thereto, and the plurality of bonding surfaces 225 may be arranged irregularly corresponding to the plurality of column units 211.

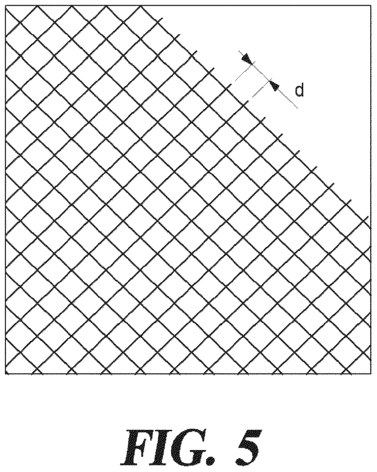

FIG. 5 is a diagram illustrating the line spacing using a laser irradiator on a wick unit of the heating element cooling structure according to an embodiment of the present disclosure.

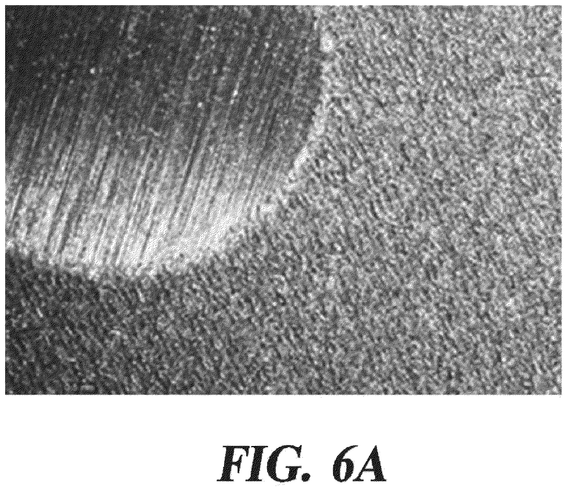

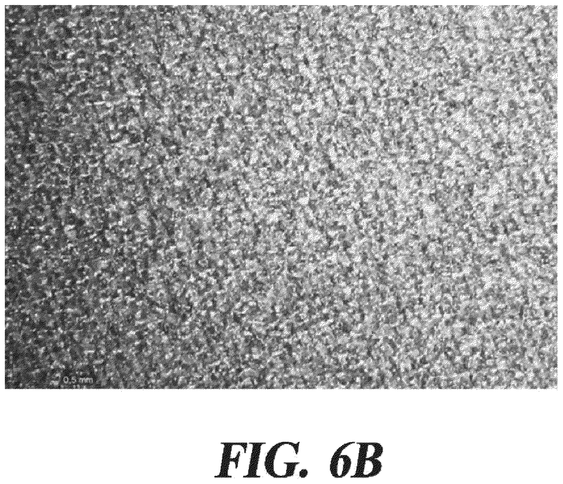

FIG. 6 is a diagram illustrating the pattern shape of the wick unit of the heating element cooling structure according to an embodiment of the present disclosure.

Referring to FIGS. 5 and 6, the spacing d of the line on which the laser beam is irradiated may be at least 0.01 mm. This is because when the line spacing d is too wide, the capillary force disappears and the water path does not exist, making it impossible to implement anti-gravity characteristics. When the capillary force between the upper plate 210 (*see* FIG. 2) and the lower plate 220 (*see* FIG. 2) and the wick unit 230 (*see* FIG. 2) is small, considering the flow of refrigerant according to temperature changes inside the heating element cooling structure 200, there is a design limitation in that a heat source needs to be always located at a low location and a heat dissipation portion needs to be always located at a high location. Accordingly, it is desirable to design the line spacing d irradiated by the laser beam to be limited to the limit at which capillary force occurs.

The wick unit 230 formed by the laser irradiator may be processed into one or more of a cross pattern ((a) of FIG. 6) and a block pattern ((b) of FIG. 6). In addition, although not shown in the drawing, the wick unit 230 may be processed into a pattern shape having an 'e' shape so as to connect continuously from the heat source to the heat dissipation portion.

The heating element cooling structure 200 according to an embodiment of the present disclosure may precisely and quickly form the wick unit 230 using the laser irradiator. The heating element cooling structure 200 may irradiate a laser beam by fixing the upper plate 210 and/or the lower plate 220 on a processing lathe and installing the laser irradiator on the processing lathe.

The moving speed and moving direction of the laser irradiator may be set according to the pattern shape of the wick unit 230. For example, an appropriate mark speed may be set to 300 mm/s. When the mark speed of the laser beam is too fast, the amount of heat transferred to the upper plate 210 and/or lower plate 220 in the form of a laser beam is too small, making it impossible to form the wick unit 230 of the desired pattern. When the mark speed is too slow, the amount of heat transferred to the upper plate 210 and/or lower plate 220 in the form of a laser beam is too large, and the size of the wick unit 230 is deformed larger than the required size of the wick unit 230.

The oscillation frequency of the laser beam may be set within the range of 20 to 40 kHz, and the laser beam may be oscillated in pulse mode. When the upper plate 210 and the lower plate 220, which are base materials, are made of aluminum, the oscillation frequency of the laser beam of the laser irradiator for forming the wick unit 230 is most appropriate in the range of 20 to 40 kHz as described above.

Although exemplary embodiments of the present disclosure have been described for illustrative purposes, those skilled in the art will appreciate that various modifications, additions, and substitutions are possible, without departing from the idea and scope of the claimed invention. Therefore, exemplary embodiments of the present disclosure have been described for the sake of brevity and clarity. The scope of the technical idea of the present embodiments is not limited by the illustrations. Accordingly, one of ordinary skill would understand the scope of the claimed invention is not to be limited by the above explicitly described embodiments but by the claims and equivalents thereof.

### [REFERENCE NUMERICALS]

200: heating element cooling structure
210: upper plate
211: column unit
220: lower plate
230: wick unit

### [CROSS-REFERENCE TO RELATED APPLICATION]

This application claims priority to and the benefit of Korean Patent Applications No. 10-2021-0163821, filed on November 24, 2021, and No. 10-2022-0155784, filed on November 18, 2022, the disclosure of which is incorporated herein by reference in its entirety.

## Claims

1. A method for manufacturing a heating element cooling structure, the method comprising:
manufacturing an upper plate, which includes a plurality of column units, by using a press mold method;
manufacturing a lower plate by using the press mold method;
forming a wick unit at one or more of an inner surface of the upper plate and an inner surface of the lower plate by using a laser; and
bonding the upper plate and the lower plate to each other.

2. The method of claim 1, further comprising bonding the column unit to the lower plate.

3. The method of claim 1, wherein the manufacturing of the upper plate comprises forming the column unit to be concave on an outer surface of the upper plate and protrude to the inner surface of the upper plate.

4. The method of claim 1, wherein the formation of the wick unit comprises forming the wick unit on the remaining portions excluding a portion bonded to the lower plate on the inner surface of the upper plate.

5. The method of claim 1, wherein the formation of the wick unit comprises forming the wick unit on the remaining portions excluding a bonding unit where the column unit and the lower plate are bonded to each other on the inner surface of the upper plate.

6. The method of claim 1, wherein the formation of the wick unit comprises forming the wick unit on the remaining portions excluding a bonding surface bonded to the upper plate on the inner surface of the upper plate.

7. The method of claim 1, further comprising injecting a refrigerant into the heating element cooling structure and sealing the heating element cooling structure.

8. A heating element cooling structure, comprising:
a lower plate;
an upper plate configured to be bonded to an inner surface of the lower plate to form an internal space;
a column unit formed to be concave on an outer surface of the upper plate and protrude to an inner surface of the upper plate; and
a wick unit formed at one or more of the inner surface of the upper plate and the inner surface of the lower plate and configured to move a refrigerant.

9. The heating element cooling structure of claim 8, wherein the column unit is bonded to the inner surface of the lower plate.

10. The heating element cooling structure of claim 8, wherein the column unit is formed integrally with the upper plate.

11. The heating element cooling structure of claim 8, wherein the wick unit is formed on the inner surface of the upper plate and the inner surface of the lower plate, excluding a portion where the upper plate and the lower plate are bonded to each other.

12. The heating element cooling structure of claim 8, wherein the upper plate and the lower plate are bonded using a laser.

13. The heating element cooling structure of claim 8, wherein an outer surface of the lower plate is disposed to be in close contact with a heating element.

14. The heating element cooling structure of claim 8, wherein the wick unit is configured to move the refrigerant using capillarity.

15. The heating element cooling structure of claim 9, wherein the column unit is bonded to the inner surface of the lower plate using laser welding.
